# EUROPÄISCHE PATENTANMELDUNG

(11) **EP 1 457 820 A2**
(43) Veröffentlichungstag der Anmeldung: **15.09.2004**
(21) Anmeldenummer: 03008306.7
(22) Anmeldetag: 10.04.2003
(51) Int. Cl.: G03F 7/032

(54) **Wässrige Entwicklerlösung für Offset-Druckplatten**

(30) Priorität: 08.03.2003 DE 10310168
(71) Anmelder: Huber GmbH, 53842 Troisdorf (DE)
(72) Erfinder: Romeike, Andres, 51427 Bergisch Gladbach (DE); Huber, Ulrich, 53819 Neunkirchen (DE)
(74) Vertreter: Gesthuysen, von Rohr & Eggert

(57) **Zusammenfassung**

Um die Stabilität von wässrigen alkalischen Entwicklern für Offset-Druckplatten in der Entwicklungsmaschine und die Lebensdauer der Platten zu erhöhen, enthält der Entwickler als Netzmittel ein Kationtensid. Er kann noch dadurch verbessert werden, daß er für den vorgesehenen Arbeitsbereich abgepuffert ist.

## Beschreibung

Die Erfindung betrifft allgemein die Druckformherstellung, insbesondere die Entwickler und deren Regenerierungsmittel für Offsetdruckplatten.

Der Offsetdruck basiert auf der Tatsache, dass Öl und Wasser sich abstoßen. Die Bildteile sind oleophil und nehmen das ölige Medium, die Druckfarbe an, die Nichtbildteile sind hydrophil und nehmen das Feuchtwasser an.
Für diesen Prozess werden in der Praxis heute meist Aluminiumträger verwendet, die an der Oberfläche chemisch aufgerauht und/oder anodisiert und mit einer lichtempfindlichen Schicht versehen sind. Je nach Beschaffenheit der Schicht reagiert diese auf Licht und wird latent gehärtet oder gelöst. Bei positiv arbeitenden Schichten wird die Schicht latent gelöst.
Die Belichtung des beschichteten Trägers, allgemein als Offsetdruckplatte bezeichnet, kann direkt von einer Laserdiode, auch CtP Belichter (Computer to plate) genannt oder über eine Filmvorlage und Belichtungsvorrichtung erfolgen.
Die belichteten Offsetdruckplatten werden nach der Belichtung in einer wässrigen, alkalischen Lösung entwickelt. Dabei werden nichtdruckende Teile der Schicht entfernt, während die druckenden Teile der Platte nicht angegriffen werden dürfen und vom Entwickler geschont werden müssen.

Zum Offsetdruck und zum prinzipiellen Unterschied zwischen Positiv- und Negativ-Kopierverfahren wird verwiesen auf Römpp, Chemie-Lexikon, Stichwort *Offsetdruck.*

Bekannte Entwicklerlösungen bestehen gewöhnlich überwiegend aus einem Gemisch von Alkalisilikat, Kali- oder Natronlauge und/oder einem Alkalimetasilikat. Sie können auch Entschäumer, Enthärter und Netzmittel, wie z.B. nicht-ionogene Tenside (DE-C-32 23 386) enthalten.
Diese Entwicklerlösungen haben den Nachteil, dass sie in den Entwicklungsmaschinen eine eingeschränkte Stabilität aufweisen. Stabilere Entwickler, die eine längere Lebensdauer aufweisen, sind in der Regel aggressiver. Dies hat zur Folge, dass die druckenden Teile der Offsetdruckplattenschicht und die Oxydschicht der Platte angegriffen werden. Die Folge ist eine eingeschränkte Lebensdauer der Platte und eine übermäßige Schlammbildung in der Plattenentwicklungsmaschine.

Aufgabe der Erfindung ist es, die erwähnten Nachteile zu beheben und einen neuartigen wässrigen Entwickler für positiv arbeitende Offsetdruckplatten mit verbessertem Schichtschutz der Platte und hoher gleichbleibender Stabilität in der Entwicklungsmaschine zu schaffen.

Der erfindungsgemässe wässrige alkalische Entwickler für Offsetdrucken enthält außer den üblichen Bestandteilen, wie Alkalimetasilikat und Alkalisilikat ein Kationentensid, und zwar bevorzugt eine quarternäre Ammoniumverbindung. Es hat sich als vorteilhaft herausgestellt, wenn diese wenigstens eine langkettige Alkylgruppe mit Etherbindungen und/oder Hydroxylgruppen aufweist, wie sie in Form von Ethylen- oder Propylenoxidpolymeren vorliegen. Solche quarternären Ammoniumverbindungen sind z.B. in Form von Poly[oxy-(methyl-1,2-ethanediyl)], alpha-[2-(diethylmethylammonio)ethyl]- -hydroxy, chlorid im Handel. Bezogen auf die Entwicklerlösung beträgt der Anteil des Kationentensids im allgemeinen 0,05 bis 1 Gewichtsprozent.

Es hat sich ferner herausgestellt, dass der erfindungsgemässe Entwickler noch wesentlich verbessert werden kann, wenn er im vorgegebenen Arbeitsbereich durch ein Puffersystem, insbesondere im Bereich von pH 12,8 bis 13,6 abgepuffert ist. Das erfindungsgemäß eingesetzte Puffersystem enthält bevorzugt Phosphorsäure und Phosphorsäurealkylester, auch Alkyletherphosphat genannt. Für die Zwecke der Erfindung werden Mono- oder Dialkylester von Polyphosphorsäuren, insbesondere Alkoxyalkylester, wie z.B. 1-Oxyethylester, bevorzugt.
Die Ester der (Poly)phosphorsäure werden insbesondere in Mengen von 0,1 bis 1,5 % zusammen mit 0,05 bis 0,5 Gewichtsprozent Phosphorsäure, bezogen auf die Entwicklerlösung, eingesetzt.

Es hat sich gezeigt, daß sich die Abpufferung, insbesondere mit dem (Poly)phosphorsäurealkylester/Phosphorsäure-System mit den quarternären Ammoniumverbindungen ausgesprochen günstig auf die Stabilität und Standzeit des Entwicklers auswirkt und keine Verschlammung in der Plattenentwicklungsmaschine mehr auftritt.

Gegenstand der Erfindung ist damit auch ein Verfahren zum Entwickeln von belichteten Offset-Positiv-Druckplatten, insbesondere Thermoplatten, bei dem der Leitwert der Entwicklerlösung durch Zugabe frischer Entwicklunglösung oder Regeneratlösung bei ± 2 % konstant gehalten wird.
Der Leitwert des Entwicklers ist der Referenzwert für die Stärke des Entwicklers. In Stabilitätstests wird der Abfall des Leitwertes nach 12, 24 und 48 Stunden gemessen.

Gegenstand der Erfindung ist ferner die Verwendung der erfindungsgemässen Entwicklerlösung für Positiv-Offsetdruckplatten, insbesondere für Thermal- oder Thermoplatten.

Die üblichen Bestandteile der wässrigen Entwicklerlösung sind eine wässrige Lösung von Natriumsilikat (<40 %), die als Natronwasserglas im Handel ist und Natriummetasilikat-5-Hydrat, auch als Dinatriumtrioxosilikat-pentahydrat bezeichnet. Es kann sich auch ganz oder teilweise um die entsprechenden Kaliumverbindungen handeln. Der Gehalt dieser Alkaliverbindungen beträgt 3 bis 20 Gew.-% der Entwicklerlösung mit 8 bis 12 Gew.-% Metasilikat und 1 bis 2 Gew.-% Wasserglas.

Es hat sich als zweckmässig erwiesen, der Lösung auch noch Enthärtungsmittel zuzusetzen, wie sie z.B. in Form der TRILON®-Produkte, insbesondere als Trinatriumsalz der Hydroxyethylethylendiamintriessigsäure im Handel sind. Ihre Menge richtet sich nach der Härte des für die Zubereitung der Entwicklerlösung verwendeten Wassers und liegt im allgemeinen im Bereich von 0,05 bis 0,5 Gewichtsprozent der Lösung.

Um ein Schäumen der Entwicklerlösung in der Plattenentwicklungsmaschine zu verhindern, wird üblicherweise ein Entschäumer zugesetzt. Dabei handelt es sich zumeist um Silikonzubereitungen, insbesondere solche von Polydimethylsiloxan. Solche sind beispielsweise unter der Bezeichnung ANTIFOAM RD EMULSION der Firma Dow Corning im Handel.

Im allgemeinen hat der erfindungsgemässe wässrige alkalische Entwickler für Offsetdruckplatten einen Alkalianteil im Bereich von 3 bis 20 Gewichtsprozent, die Tensidmenge liegt bei 0,05 bis 1 Gewichtsprozent, der Gehalt des Esters der Polyphosphorsäure bei 0,1 bis 1,5 und der der Phosphorsäure bei 0,05 bis 0,5 %. Dazu können noch der Entschäumer und der Enthärter kommen, der Rest ist Wasser.

Eine bevorzugte Zusammensetzung der erfindungsgemässen Entwicklerlösung ist folgende:

| | |
|---|---|
| 8 bis 12 Gew.-% | Natriummetasilikat |
| 1 bis 2 Gew.-% | Natronwasserglas |
| 0,05 bis 0,5 Gew.-% | quarternäre Trialkylammoniumverbindung mit Polyalkoxykette |
| 0,1 bis 0,5 Gew.-% | Polyphosphorsäure-2-oxyethylester |
| 0,025 bis 0,15 Gew.-% | Antifoam Dow Corning |
| 0,05 bis 0,5 Gew.-% ad 100 Gew.-% | TRILON D flüssig Wasser |

Bei der Herstellung der klaren Entwicklerlösung und insbesondere einer Regeneratlösung mit der 1,5 bis 3-fachen Konzentration empfiehlt es sich, bei der Herstellung der Lösung die berechnete zusätzliche Wassermenge vorzulegen und dann der Reihe nach den Enthärter, das Metasilikat, die Pufferbestandteile, das Netzmittel und schliesslich den Entschäumer zuzugeben.

### BEISPIEL

| | |
|---|---|
| 12 Gew.-% | Natriummetasilikat |
| 1 Gew.-% | Natronwasserglas |
| 0,1 Gew.-% | quarternäre Trialkylammoniumverbindung mit Polyalkoxykette |
| 0,1 Gew.-% | Polyphosphorsäure-2-oxyethylester |
| 0,02 Gew.-% | Antifoam Dow Corning |
| 0,05 Gew.-% | TRILON D flüssig Rest Wasser |

Eine vorbeschichtete, konventionelle Aluminiumoffsetplatte (AGFA P 5S) wird in einen Glasrahmen auf eine glatte Unterlage gelegt, darauf wird die Filmvorlage positioniert und mit Hilfe einer Vakuumvorrichtung werden Platte und Film aneinander gepresst. Die Platte wird mit einer UV Lampe des Belichtungsgerätes belichtet. Zur Kontrolle der Belichtung und Entwicklung wird ein UGRA Kontrollstreifen auf die Platte gelegt (s. FOGRA-PMS und UGRA-Offset Testkeil 1982, Anleitung zum Gebrauch, Dr. Friedrich Dolezalek, in FOGRA Praxis Report 34, Juni 1997).
In einem weiteren Test wurden Aluminium-Offsetdruckplatten der neuesten Technik, nämlich die Thermal-Direkt-Belichtungsplatte AGFA P 970 direkt auf einem CREO-Trendsetter-Belichter und einem Computer mittels einer Laserlichtquelle belichtet.

Nach der Belichtung erfolgt die Entwicklung in der Plattenentwicklungsmaschine. Im ersten Abschnitt des Tauchbades der Entwicklungsmaschine wird zunächst die belichtete Schicht aufgeweicht und dann im zweiten Abschnitt mit Unterstützung von Bürsten entfernt. Die Schicht soll sich dabei im Entwickler vollkommen auflösen.

Es wurden jeweils folgende Tests vorgenommen:
Stabilitätstests: Abfall des Leitwertes nach 12, 24, 48 Stunden.
Beobachtung von Trübung und Ausflockungen nach 24 und 48 Stunden.
Entwicklungstest von positiv arbeitenden Offsetdruckplatten in der Plattenentwicklungsmaschine: Beurteilung des Ugra Testkeils. Auf dem Keil befinden sich 13 Stufenkeile, die mehr oder weniger entwickelt werden. Bei der Beurteilung der Entwicklung werden die Stufen gezählt, die von vollkommen entwickelt bis keine Entwicklung reichen.
Beobachtung, ob eine Verschlammung oder ein Kristallisieren in der Maschine auftritt.

| Ergebnisse: | konventionelle Platte Agfa P 5S belichtet in einem konventionellen Belichtungsrahmen | Thermal Direktbelichtungsplatte Agfa P 970 belichtet auf einem CREO-Trendsetter Belichter |
|---|---|---|
| Stabilitätstest | | |
| Leitwert (mS) nach | 80 | 80 |
| 12 Stunden | 78 | 78 |
| 24 Stunden | 76 | 76 |
| 48 Stunden | 74 | 74 |
| Trübung / Ausflockungen | | |
| 24 Stunden | keine | keine |
| 48 Stunden | keine | keine |
| UGRA Testkeil | | |
| Entwicklungsstufen | | |
| von offen bis zu | 4 | ― |
| Verschlammung/ Kristallisieren nach 1 Woche, Entwicklung von ca.1000 m² Platten | keine | keine |

## Patentansprüche

1. Wässriger, alkalischer Entwickler für Offsetdruckplatten, enthaltend Alkalimetasilikat, Alkalisilikat, Netzmittel und gegebenenfalls Entschäumer und Enthärter, **dadurch gekennzeichnet, daß** er ein Kationtensid enthält.

2. Entwickler nach Anspruch 1, **dadurch gekennzeichnet, daß** er eine quarternäre Ammoniumverbindung enthält.

3. Entwickler nach Anspruch 1 oder 2, **dadurch gekennzeichnet, daß** die Alkylreste der quaternären Ammoniumverbindung Oxyalkylgruppen enthalten.

4. Entwickler nach einem der Ansprüche 1 bis 3, **dadurch gekennzeichnet, daß** er ein Puffersystem für den vorgegebenen Arbeitsbereich des Entwicklers enthält.

5. Entwickler nach einem der Ansprüche 1 bis 4, **dadurch gekennzeichnet, daß** das Puffersystem den Entwickler im Bereich von pH 12,8 bis 13,6 abpuffert.

6. Entwickler nach einem der Ansprüche 1 bis 5, **dadurch gekennzeichnet, daß** das Puffersystem Phosphorsäure enthält.

7. Entwickler nach einem der Ansprüche 1 bis 6, **dadurch gekennzeichnet, daß** das Puffersystem Phosphorsäurealkylester enthält.

8. Entwickler nach einem der Ansprüche 1 bis 7, **dadurch gekennzeichnet, daß** das Puffersystem (Poly)phosphorsäuremono- oder Dialkylester enthält.

9. Entwickler nach einem der Ansprüche 1 bis 8, **dadurch gekennzeichnet, daß** der (Poly)phosphorester ein Alkoxyalkylester ist.

10. Entwickler nach einem der Ansprüche 1 bis 9, **dadurch gekennzeichnet, daß** der Polyphosphorsäureester ein 1-Butoxyethylester ist.

11. Entwickler nach einem der Ansprüche 1 bis 10, **dadurch gekennzeichnet, daß** das Alkalimetasilikat Natriummetasilikat ist.

12. Entwickler nach einem der Ansprüche 1 bis 11, **dadurch gekennzeichnet, daß** das Alkalisilikat Natriumwasserglas ist.

13. Entwickler nach einem der Ansprüche 1 bis 12, **dadurch gekennzeichnet, daß** er einen Entschäumer enthält.

14. Entwickler nach einem der Ansprüche 1 bis 13, **dadurch gekennzeichnet, daß** er als Enthärter Alkalisalze der Nitriloessigsäure enthält.

15. Entwickler nach einem der Ansprüche 1 bis 14, **dadurch gekennzeichnet, daß** das Trinatriumsalz der Nitriloessigsäure in einer Menge von 0,05 bis 0,5 Gew.-% vorliegt.

16. Entwickler nach einem der Ansprüche 1 bis 15, **dadurch gekennzeichnet, daß** der Anteil der
Alkalisilikatverbindungen im Bereich von 3 - 20 Gew.-%,
des Tensids bei 0,05 bis 1,0 Gew.-%,
der Ester der Polyphosphorsäure bei 0,1 bis 1,5 Gew.-% und
der Phosphorsäure bei 0,05 bis 0,5 Gew.-% liegt.

17. Entwickler nach einem der Ansprüche 1 bis 16, **dadurch gekennzeichnet, daß** er als Regenerat die Bestandteile in der 1.5 bis 3-fachen Konzentration enthält.

18. Verwendung des Entwicklers nach einem der Ansprüche 1 bis 17 für Positiv-Offsetdruckplatten.

19. Verwendung nach Anspruch 18 für CtP-Druckplatten, insbesondere für Thermal- oder Thermoplatten.

20. Verfahren zum Entwickeln von belichteten Offset-Positiv-Druckplatten, insbesondere Thermoplatten, **dadurch gekennzeichnet, daß** der Leitwert der Entwicklerlösung durch Zugabe frischer Entwicklerlösung oder Regeneratlösung bei ± 2 % konstant gehalten wird.
